# EUROPÄISCHE PATENTSCHRIFT

(11) **EP 4 070 373 B1**
(45) Veröffentlichungstag und Bekanntmachung des Hinweises auf die Patenterteilung: **17.01.2024**
(21) Anmeldenummer: 20707023.6
(22) Anmeldetag: 19.02.2020
(51) Int. Cl.: H01L 23/525, H01L 23/62, H01H 39/00

(54) **KURZSCHLUSSSCHALTEINRICHTUNG**
SHORT-CIRCUIT SWITCHING DEVICE
DISPOSITIF DE COMMUTATION À COURT-CIRCUIT

(43) Veröffentlichungstag der Anmeldung: 12.10.2022
(73) Patentinhaber: Siemens Energy Global GmbH & Co. KG, 81739 München (DE)
(72) Erfinder: SCHREMMER, Frank, 90768 Fürth (DE); ZENKNER, Andreas, 90587 Veitsbronn (DE)
(86) Internationale Anmeldenummer: PCT/EP2020/054293
(87) Internationale Veröffentlichungsnummer: WO 2021/164858

(56) Entgegenhaltungen:
- WO-A1-2013/044961
- WO-A1-2013/044965
- WO-A1-2019/011717
- DE-A1-102014 207 928
- DE-A1-102016 006 720

## Beschreibung

Die Erfindung bezieht sich auf Kurzschlussschalteinrichtungen, insbesondere in Form von Bypassschaltern, Anordnungen, die mit Kurzschlussschalteinrichtungen ausgestattet sind, und Verfahren zum Betreiben von Kurzschlussschalteinrichtungen. In leistungselektronischen Anlagen, beispielsweise Umrichtanordnungen, Multilevelumrichtern, Spannungsstabilisierungseinrichtungen, Blindleistungsstellern, etc., besteht das Problem, dass unter Umständen Teile der Anlagen möglichst schnell abgeschaltet werden müssen.

Bekanntermaßen kann zum Kurzschließen von Bauelementen ein mechanisch arbeitender pyrotechnischer Bypass-Schalter eingesetzt werden. Derartige mechanisch arbeitende pyrotechnische Bypass-Schalter weisen mechanische Teile auf, die durch pyrotechnische Einwirkung bewegt werden, und Schaltzeiten von weniger als eine Millisekunde erreichen können. Bekannte mechanisch arbeitende pyrotechnische Bypass-Schalter können im Falle eines Kurzschlusses beispielsweise Kurzschlussenergien von bis zu 150 Kilojoule standhalten.

Die Vorveröffentlichungen WO2019/011717, WO2013/044961, DE102014207928, DE102016006720 und WO2013/044965 beschreiben bekannte Einrichtungen zum Kurzschließen von Bauelementen.

Der Erfindung liegt die Aufgabe zugrunde, eine Kurzschlussschalteinrichtung anzugeben, die schneller als bisherige mechanisch arbeitende pyrotechnische Bypass-Schalter arbeiten kann.

Diese Aufgabe wird erfindungsgemäß durch eine Kurzschlussschalteinrichtung mit den Merkmalen gemäß Patentanspruch 1 gelöst. Vorteilhafte Ausgestaltungen der erfindungsgemäßen Kurzschlussschalteinrichtung sind in den Unteransprüchen angegeben.

Danach ist erfindungsgemäß vorgesehen, dass die Kurzschlussschalteinrichtung ein Halbleiterelement mit zumindest einem pn-Übergang und mindestens eine pyrotechnische Zündeinrichtung umfasst, wobei das Halbleiterelement vor dem Zünden der pyrotechnischen Zündeinrichtung aufgrund der Mitwirkung des pn-Übergangs den Sperrzustand aufweist oder zumindest aufweisen kann und wobei das Halbleiterelement nach dem Zünden der pyrotechnischen Zündeinrichtung von dem von der Zündeinrichtung nach einer Explosion freigesetzten Explosionsgas zumindest partiell, und zwar zumindest bezüglich des zumindest einen pn-Übergangs, zerstört und stromflussrichtungsunabhängig leitfähig gemacht wird.

Ein wesentlicher Vorteil der erfindungsgemäßen Kurzschlussschalteinrichtung ist darin zu sehen, dass durch das erfindungsgemäße Zerstören eines oder mehrerer pn-Übergänge innerhalb eines Halbleiterelements besonders kurze Schaltzeiten, beispielsweise im Mikrosekundenbereich, erreicht werden können, weil auf bewegliche mechanische Teile verzichtet werden kann. Auch ist es möglich, die erfindungsgemäße Kurzschlussschalteinrichtung beispielsweise durch entsprechende Bauteildimensionierung bezüglich auftretender Kurzschlussenergien sehr unempfindlich auszuführen.

Bei einer bevorzugten Ausgestaltung der Kurzschlussschalteinrichtung ist vorgesehen, dass die Kurzschlussschalteinrichtung eine Anode und eine Kathode umfasst, wobei das Halbleiterelement ein erstes und ein zweites n-dotiertes Halbleitergebiet aufweist, von denen das zweite mit der Kathode verbunden ist oder diese selbst bildet, wobei das Halbleiterelement ein erstes und ein zweites p-dotiertes Halbleitergebiet aufweist, von denen das erste mit der Anode verbunden ist oder diese selbst bildet, wobei das erste und das zweite n-dotierte Halbleitergebiet und das erste und das zweite p-dotierte Halbleitergebiet zwischen der Anode und der Kathode zumindest drei elektrisch in Reihe liegende pn-Übergänge bilden, nämlich einen ersten pn-Übergang zwischen dem ersten p-dotierten Halbleitergebiet und dem ersten n-dotierten Halbleitergebiet, einen zweiten pn-Übergang zwischen dem ersten n-dotierten Halbleitergebiet und dem zweiten p-dotierten Halbleitergebiet und einen dritten pn-Übergang zwischen dem zweiten p-dotierten Halbleitergebiet und dem zweiten n-dotierten Halbleitergebiet, und wobei die pyrotechnische Zündeinrichtung derart angeordnet ist, dass sie mit dem von ihr nach einer Explosion freigesetzten Explosionsgas zumindest den dritten pn-Übergang zerstört und dadurch stromflussrichtungsunabhängig leitfähig macht.

Die pyrotechnische Zündeinrichtung ist vorzugsweise derart angeordnet, dass sie mit dem von ihr nach einer Explosion freigesetzten Explosionsgas (vorzugsweise in Form von Plasma bzw. ionisiertem Gas) zumindest den zweiten und dritten pn-Übergang zerstört und stromflussrichtungsunabhängig leitfähig macht. Im Falle eines unversehrten ersten pn-Übergangs wird das Halbleiterelement dann unidirektional leitfähig werden, und zwar in Stromflussrichtung von der Anode in Richtung Kathode, weil es aufgrund des verbleibenden ersten pn-Übergangs als einfache Diode weiterarbeiten wird.

Das Halbleiterelement ist insbesondere mit Blick auf einen großen Querschnitt (mit einem Durchmesser von vorzugsweise 4 Zoll oder mehr), hohe Schaltströme und trotzdem kleine Bauhöhen (von beispielsweise weniger als 30 mm) vorzugsweise eine Halbleiterscheibe mit einer ersten und einer der ersten Scheibenseite gegenüberliegenden zweiten Scheibenseite. Der Stromfluss zwischen Anode und Kathode erfolgt vorzugsweise senkrecht zur Scheibenebene.

Die pyrotechnische Zündeinrichtung weist vorzugsweise eine Sprengladung und einen Gasleitkanal auf, der parallel zur Ebene der Halbleiterscheibe angeordnet ist und das von der Sprengladung erzeugte Explosionsgas parallel in Richtung Scheibenmitte leitet.

Das nach einer Explosion freigesetzte Explosionsgas zerstört vorzugsweise den zumindest einen pn-Übergang, insbesondere den dritten pn-Übergang, im Bereich der Scheibenmitte und macht diesen bevorzugt dort stromflussrichtungsunabhängig leitfähig.

Besonders vorteilhaft ist es, wenn das nach einer Explosion freigesetzte Explosionsgas auch den zweiten pn-Übergang im Bereich der Scheibenmitte zerstört und stromflussrichtungsunabhängig leitfähig macht.

Auch ist es von Vorteil, wenn das Halbleiterelement eine Halbleiterscheibe ist, auf deren erster Scheibenseite das erste p-dotierte Halbleitergebiet und die Anode und auf deren anderer zweiter Scheibenseite das zweite n-dotierte Halbleitergebiet und die Kathode angeordnet sind.

Die Kurzschlussschalteinrichtung umfasst vorzugsweise eine Elektrode, die auf einer der Scheibenseiten aufliegt und die Anode oder die Kathode elektrisch kontaktiert.

Der Gasleitkanal der pyrotechnischen Zündeinrichtung wird vorzugsweise durch einen kanalförmigen Hohlraum innerhalb der Elektrode, insbesondere durch ein innerhalb des kanalförmigen Hohlraums angeordnetes Röhrchen, gebildet.

Mit Blick darauf, dass Metallteilchen oder Metallionen ein Durchkontaktieren bzw. "Legieren" von pn-Übergängen fördern können, wird es als vorteilhaft angesehen, wenn die pyrotechnische Zündeinrichtung das nach einer Explosion freigesetzte Explosionsgas auf eine auf dem Halbleiterelement aufgebrachte Metallisierung oder zumindest auch auf die Metallisierung richtet.

Das erste und zweite n-dotierte Halbleitergebiet und das erste und zweite p-dotierte Halbleitergebiet bilden vorzugsweise einen Thyristor, bei dem das zweite p-dotierte Halbleitergebiet einen Gatebereich des Thyristors bildet.

Bei einer bevorzugten Ausgestaltung ist vorgesehen, dass sich das zweite p-dotierte Halbleitergebiet in Richtung zu einer der zwei Scheibenseiten erstreckt und von einer auf dieser Scheibenseite aufgebrachten Gateelektrode kontaktiert wird. Die pyrotechnische Zündeinrichtung richtet das nach einer Explosion freigesetzte Explosionsgas vorzugsweise auf die den Gatebereich kontaktierende Gatelektrode oder zumindest auch auf die Gateelektrode.

Bei einer anderen bevorzugten Ausgestaltung ist vorgesehen, dass sich das zweite p-dotierte Halbleitergebiet zu einer der zwei Scheibenseiten erstreckt, ohne von einer auf dieser Scheibenseite aufgebrachten Gateelektrode kontaktiert zu werden. Bei dieser letztgenannten Variante richtet die pyrotechnische Zündeinrichtung vorzugsweise das nach einer Explosion freigesetzte Explosionsgas auf das unkontaktierte zweite p-dotierte Halbleitergebiet.

Bei einer wiederum anderen bevorzugten Ausgestaltung ist vorgesehen, dass das zweite p-dotierte Halbleitergebiet von einer der zwei Scheibenseiten durch das zweite n-dotierte Halbleitergebiet getrennt wird. Bei dieser letztgenannten Variante richtet die pyrotechnische Zündeinrichtung vorzugsweise das nach einer Explosion freigesetzte Explosionsgas auf das unkontaktierte zweite n-dotierte Halbleitergebiet.

Bei einer wiederum anderen bevorzugten Ausgestaltung ist vorgesehen, dass das zweite p-dotierte Halbleitergebiet von einer der zwei Scheibenseiten durch das zweite n-dotierte Halbleitergebiet getrennt wird und sich die Kathode in den Bereich erstreckt, auf den das von der pyrotechnischen Zündeinrichtung nach einer Explosion freigesetzte Explosionsgas auf das Halbleiterelement einwirkt. Bei dieser letztgenannten Variante richtet die pyrotechnische Zündeinrichtung also vorzugsweise das nach einer Explosion freigesetzte Explosionsgas auf, das von der Kathode kontaktierte zweite n-dotierte Halbleitergebiet.

Die Erfindung bezieht sich darüber hinaus auf eine Anordnung, insbesondere in Form eines Umrichters, eines Multilevelumrichters, einer Spannungsstabilisierungseinrichtung, eines Blindleistungsstellers und/oder einer Blindleistungskompensationsanlage, mit zumindest einer Modulreihenschaltung mit mindestens zwei elektrisch in Reihe geschalteten Teilmodulen und einer Steuereinrichtung zum Ansteuern der Teilmodule. Erfindungsgemäß ist vorgesehen, dass die Anordnung zumindest eine Kurzschlussschalteinrichtung aufweist, wie sie oben beschrieben worden ist.

Bezüglich der Vorteile der erfindungsgemäßen Anordnung sowie vorteilhafter Ausgestaltungen der erfindungsgemäßen Anordnung sei auf die obigen Ausführungen im Zusammenhang mit der erfindungsgemäßen Kurzschlussschalteinrichtung verwiesen.

Vorteilhaft ist es, wenn die zumindest eine Kurzschlussschalteinrichtung Bestandteil eines der Teilmodule ist und parallel zu den äußeren Anschlüssen des Teilmoduls geschaltet ist und diese kurzschließen kann.

Die Erfindung bezieht sich darüber hinaus auf ein Verfahren zum Betreiben einer Kurzschlussschalteinrichtung, insbesondere eines Bypassschalters.

Erfindungsgemäß ist vorgesehen, dass die Kurzschlussschalteinrichtung ein Halbleiterelement mit zumindest einem pn-Übergang und mindestens eine pyrotechnische Zündeinrichtung umfasst, wobei das Halbleiterelement vor dem Zünden der pyrotechnischen Zündeinrichtung unter der Mitwirkung des pn-Übergangs in den Sperrzustand geschaltet wird und wobei das Halbleiterelement durch Zünden der pyrotechnischen Zündeinrichtung mit dem von der Zündeinrichtung nach einer Explosion freigesetzten Explosionsgas zumindest partiell, und zwar zumindest bezüglich des zumindest einen pn-Übergangs, zerstört und stromflussrichtungsunabhängig leitfähig gemacht wird.

Bezüglich der Vorteile des erfindungsgemäßen Verfahrens sowie vorteilhafter Ausgestaltungen des erfindungsgemäßen Verfahrens sei auf die obigen Ausführungen im Zusammenhang mit der erfindungsgemäßen Kurzschlussschalteinrichtung verwiesen.

Die Erfindung wird nachfolgend anhand von Ausführungsbeispielen näher erläutert; dabei zeigen beispielhaft
- Figur 1: ein Ausführungsbeispiel für eine erfindungsgemäße Kurzschlussschalteinrichtung vor dem Auslösen einer Zündeinrichtung der Kurzschlussschalteinrichtung,
- Figur 2: die Kurzschlussschalteinrichtung gemäß Figur 1 nach dem Auslösen der Zündeinrichtung,
- Figur 3: ein Ausführungsbeispiel für eine erfindungsgemäße Kurzschlussschalteinrichtung, bei der ein Gasleitkanal durch einen kanalförmigen Hohlraum in einer Elektrode gebildet wird,
- Figur 4: ein Ausführungsbeispiel für eine erfindungsgemäße Kurzschlussschalteinrichtung ohne Gateelektrode,
- Figur 5: ein Ausführungsbeispiel für eine erfindungsgemäße Kurzschlussschalteinrichtung mit durchgängiger Kathode,
- Figur 6: ein Ausführungsbeispiel für einen erfindungsgemäßen Umrichter, der mit Kurzschlussschalteinrichtungen ausgestattet ist,
- Figur 7: ein Ausführungsbeispiel für ein Teilmodul, das zur Bildung von Modulreihenschaltungen bei dem Umrichter gemäß Figur 6 eingesetzt werden kann, und
- Figur 8: ein weiteres Ausführungsbeispiel für ein Teilmodul, das zur Bildung von Modulreihenschaltungen bei dem Umrichter gemäß Figur 6 eingesetzt werden kann.

In den Figuren werden der Übersicht halber für identische oder vergleichbare Komponenten stets dieselben Bezugszeichen verwendet.

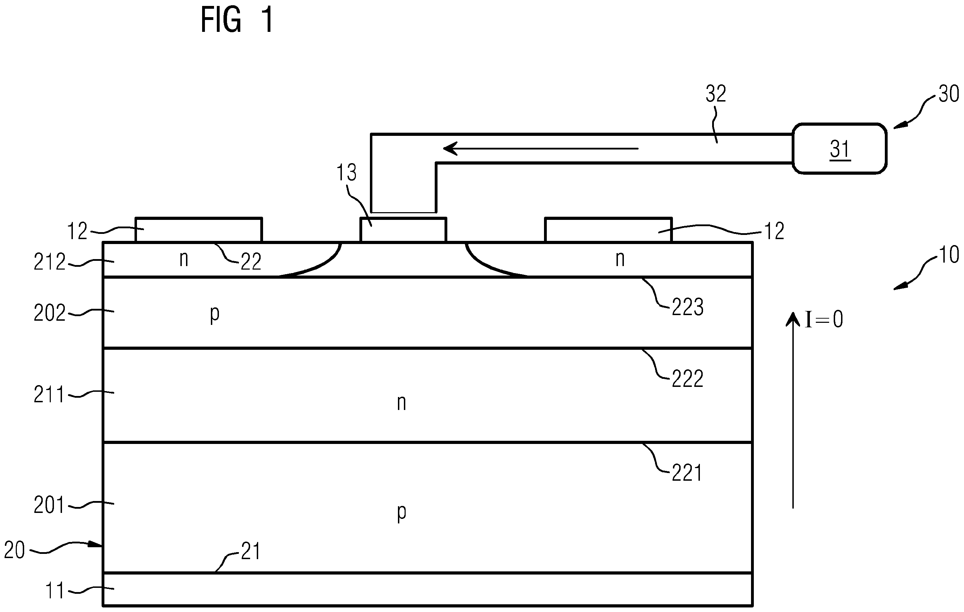

Die Figur 1 zeigt ein erstes Ausführungsbeispiel für eine erfindungsgemäße Kurzschlussschalteinrichtung 10. Die Kurzschlussschalteinrichtung 10 umfasst ein Halbleiterbauelement 20 und eine pyrotechnische Zündeinrichtung 30.

Das Halbleiterbauelement 20 wird bei dem Ausführungsbeispiel gemäß Figur 1 durch eine Halbleiterscheibe gebildet, die eine in der Figur 1 untere erste Scheibenseite 21 und eine in der Figur 1 obere zweite Scheibenseite 22 umfasst.

Das Halbleiterbauelement 20 weist ein erstes p-dotiertes Halbleitergebiet 201, ein zweites p-dotiertes Halbleitergebiet 202, ein erstes n-dotiertes Halbleitergebiet 211 und ein zweites n-dotiertes Halbleitergebiet 212 auf. Die vier Halbleitergebiete 201, 202, 211 und 212 bilden insgesamt drei pn-Übergänge innerhalb des Halbleiterbauelements 20, nämlich einen ersten pn-Übergang 221 zwischen dem ersten p-dotierten Halbleitergebiet 201 und dem ersten n-dotierten Halbleitergebiet 211, einen zweiten pn-Übergang 222 zwischen dem ersten n-dotierten Halbleitergebiet 211 und dem zweiten p-dotierten Halbleitergebiet 202 und einen dritten pn-Übergang 223 zwischen dem zweiten p-dotierten Halbleitergebiet 202 und dem zweiten n-dotierten Halbleitergebiet 212.

Die vier Halbleitergebiete bzw. die drei pn-Übergänge bilden einen Thyristor, bei der das erste p-dotierte Halbleitergebiet 201 durch eine Anode 11, das zweite n-dotierte Halbleitergebiet 212 durch eine Kathode 12 und das zweite p-dotierte Halbleitergebiet 202 durch eine Gateelektrode 13 kontaktiert werden.

Die pyrotechnische Zündeinrichtung 30 umfasst bei dem Ausführungsbeispiel gemäß Figur 1 eine Sprengladung 31, die über einen Gasleitkanal 32 mit der Scheibenmitte auf der zweiten Scheibenseite 22 des Halbleiterbauelements 20 in Verbindung steht. Ein Ende des Gasleitkanals 32 ist auf die Gateelektrode 13 gerichtet und führt ein im Falle einer Zündung der Sprengladung 31 von der Sprengladung 31 erzeugtes Explosionsgas G zur Gateelektrode 13 bzw. zur Scheibenmitte des Halbleiterbauelements 20.

Das Halbleiterbauelement 20, die Anode 11, die Kathode 12 und die Gateelektrode 13 können durch einen herkömmlichen bzw. kommerziell erhältlichen Thyristor gebildet sein, wie er allgemein bekannt ist und beispielsweise im Bereich der Umrichtertechnik eingesetzt wird. Im Unterschied zu einer herkömmlichen Beschaltung des Thyristors fehlt es bei dem Ausführungsbeispiel gemäß Figur 1 an einer elektrischen Kontaktierung der Gateelektrode 13, denn das Zünden des Thyristors wird nicht elektrisch, sondern pyrotechnisch hervorgerufen, weshalb die Gateelektrode 13 lediglich mit dem Gasleitkanal 32 und der Sprengladung 31 in Verbindung steht.

Vor einem Zünden der Sprengladung 31 ist die Kurzschlussschalteinrichtung 10 in einem elektrischen Sperrzustand bzw. stromlos, weil zwischen der Anode 11 und der Kathode 12 mangels Zündstrom zwischen dem zweiten p-dotierten Halbleitergebiet 202 und dem zweiten n-dotierten Halbleitergebiet 212 kein Strom I fließen kann.

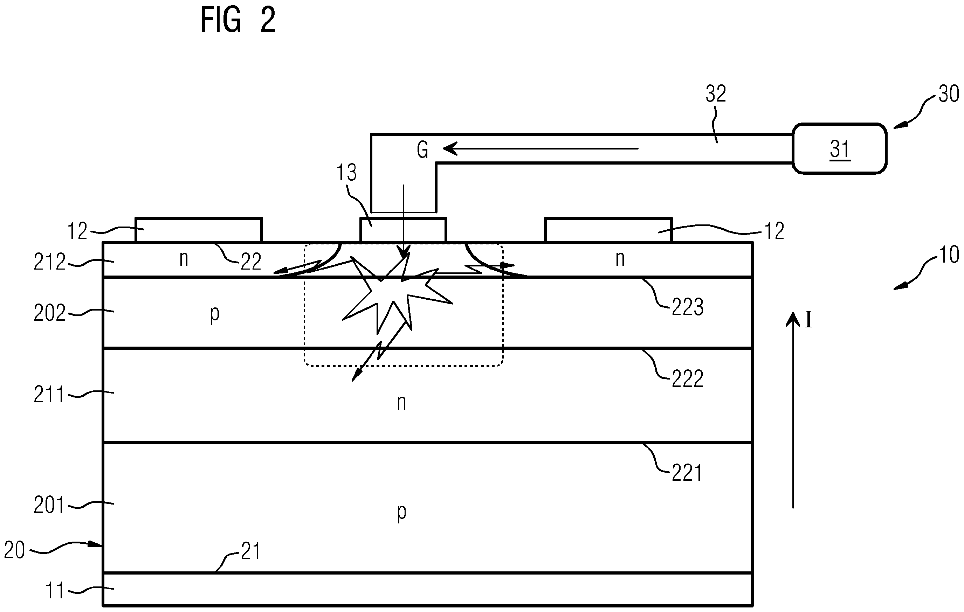

Die Figur 2 zeigt die Kurzschlussschalteinrichtung 10 gemäß Figur 1 nach einem Zünden der Sprengladung 31. Es lässt sich erkennen, dass das Explosionsgas G auf die Gateelektrode 13 eingewirkt hat und diese, den zweiten pn-Übergang 222 und den dritten pn-Übergang 223 zumindest lokal zerstört hat, sodass die beiden pn-Übergange 222 und 223 - zumindest in ihren zerstörten Bereichen - stromflussrichtungsunabhängig leitfähig gemacht werden.

Durch die Zerstörung der Halbleiterstruktur aufgrund der Einwirkung des Explosionsgases G verbleibt bei dem Halbleiterbauelement 20 lediglich ein einziger funktionsfähiger pn-Übergang, nämlich der erste pn-Übergang 221 zwischen dem ersten p-dotierten Halbleitergebiet 201 und dem ersten n-dotierten Halbleitergebiet 211. Mit anderen Worten verbleibt elektrisch lediglich eine pn-Diode, die zwischen der Anode 11 und der Kathode 12 entlang der in der Figur 2 eingezeichneten Stromflussrichtung I leitfähig ist. Die Kurzschlussschalteinrichtung 10 ist somit unidirektional leitfähig bzw. durchgeschaltet, da der ehemalige Thyristor durch eine einfache pn-Diode ersetzt worden ist.

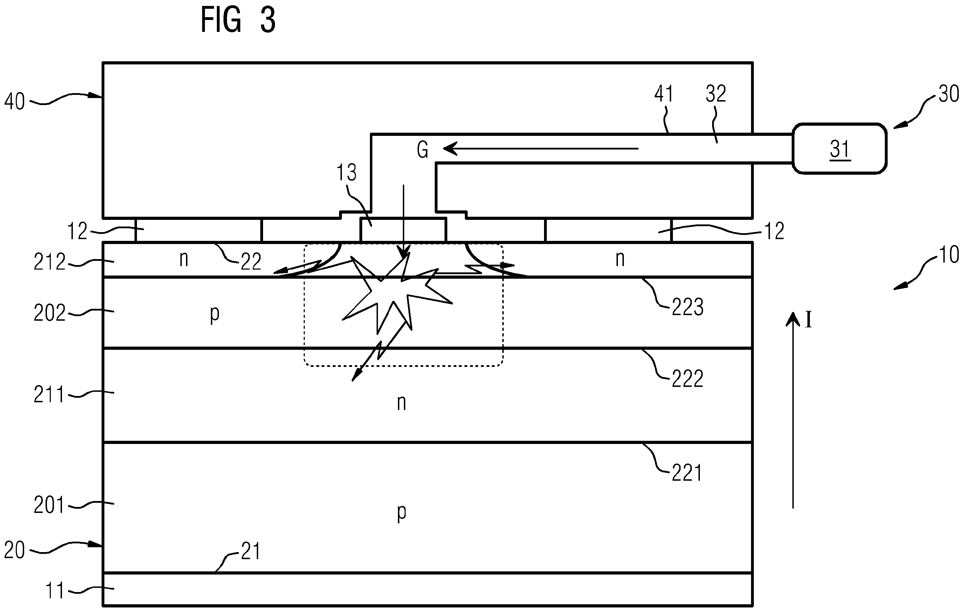

Die Figur 3 zeigt ein zweites Ausführungsbeispiel für eine erfindungsgemäße Kurzschlussschalteinrichtung 10. Bei der Kurzschlussschalteinrichtung 10 gemäß Figur 3 wird der Gasleitkanal 32 der pyrotechnischen Zündeinrichtung 30 durch einen kanalförmigen Hohlraum 41 innerhalb einer auf die Kathode 12 aufgesetzten Elektrode 40 gebildet. Die Elektrode 40 hat somit eine Doppelfunktion: Zum einen ermöglicht sie eine einfache, ganzflächige Kontaktierung der Kathode 12, und zum anderen ermöglicht sie in einfacher Weise das Weiterleiten des Explosionsgases G von der Sprengladung 31 in Richtung zur Gateelektrode 13.

Im Übrigen gelten die obigen Ausführungen im Zusammenhang mit den Figuren 1 und 2 bei dem Ausführungsbeispiel gemäß Figur 3 entsprechend.

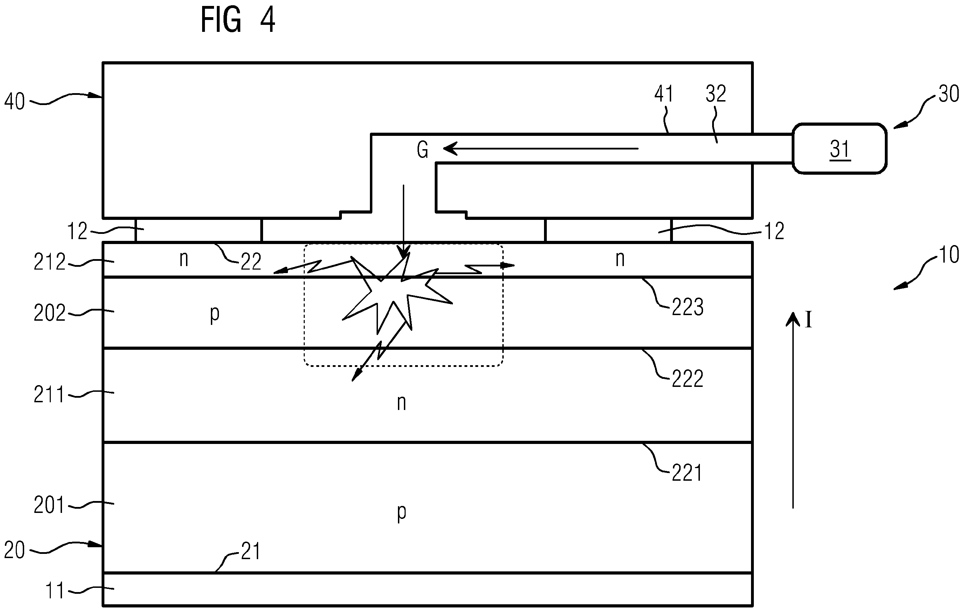

Die Figur 4 zeigt ein drittes Ausführungsbeispiel für eine erfindungsgemäße Kurzschlussschalteinrichtung 10. Bei der Kurzschlussschalteinrichtung 10 gemäß Figur 4 ist die Gateelektrode 13 weggelassen, da eine elektrische Kontaktierung des zweiten p-dotierten Halbleitergebiets 202 für die Funktionsweise der Kurzschlussschalteinrichtung 10 nicht zwingend nötig ist. Auf das Aufbringen der Gateelektrode 13 wird bei der Herstellung der Kurzschlussschalteinrichtung 10 gemäß Figur 4 also verzichtet.

Darüber hinaus ist bei dem Ausführungsbeispiel gemäß Figur 4 das zweite p-dotierte Halbleitergebiet 202 von der zweiten Scheibenseite 22 durch das zweite n-dotierte Halbleitergebiet 212 getrennt; dies ist möglich, da die Gateelektrode 13 bzw. der Gateanschluss schlicht fehlt.

Bei dem Ausführungsbeispiel gemäß Figur 4 wird das Explosionsgas G der Sprengladung 31 unmittelbar auf das zweite p-dotierte Halbleitergebiet 202 gerichtet, wodurch es - wie im Zusammenhang mit den Figuren 1 bis 3 erläutert - zu einer Zerstörung zumindest des zweiten pn-Übergangs 222 und des dritten pn-Übergangs 223 kommt. Durch die Zerstörung der beiden pn-Übergänge 222 und 223 wird aus der Thyristorstruktur des Halbleiterbauelements 20 eine einfache Diodenstruktur, die in Stromflussrichtung von der Anode 11 zur Kathode 12 leitfähig ist.

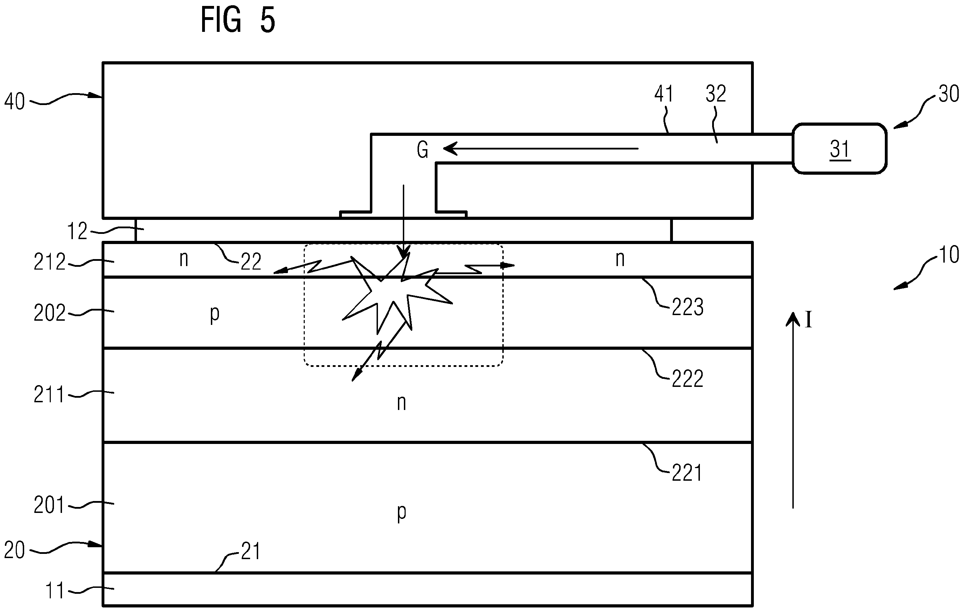

Die Figur 5 zeigt ein viertes Ausführungsbeispiel für eine erfindungsgemäße Kurzschlussschalteinrichtung 10. Bei dem Ausführungsbeispiel gemäß Figur 5 erstreckt sich die Kathode 12 über die gesamte zweite Scheibenseite 22 des Halbleiterbauelements 20. Es fehlt - ebenso wie bei dem Ausführungsbeispiel gemäß Figur 4 - eine Gateelektrode 13.

Darüber hinaus ist bei dem Ausführungsbeispiel gemäß Figur 5 das zweite p-dotierte Halbleitergebiet 202 von der zweiten Scheibenseite 22 durch das zweite n-dotierte Halbleitergebiet 212 getrennt, wie dies auch bei dem Ausführungsbeispiel gemäß Figur 4 der Fall ist.

Im Übrigen gelten die obigen Ausführungen im Zusammenhang mit den ersten drei Ausführungsbeispielen gemäß den Figuren 1 bis 4 bei dem vierten Ausführungsbeispiel gemäß Figur 5 entsprechend.

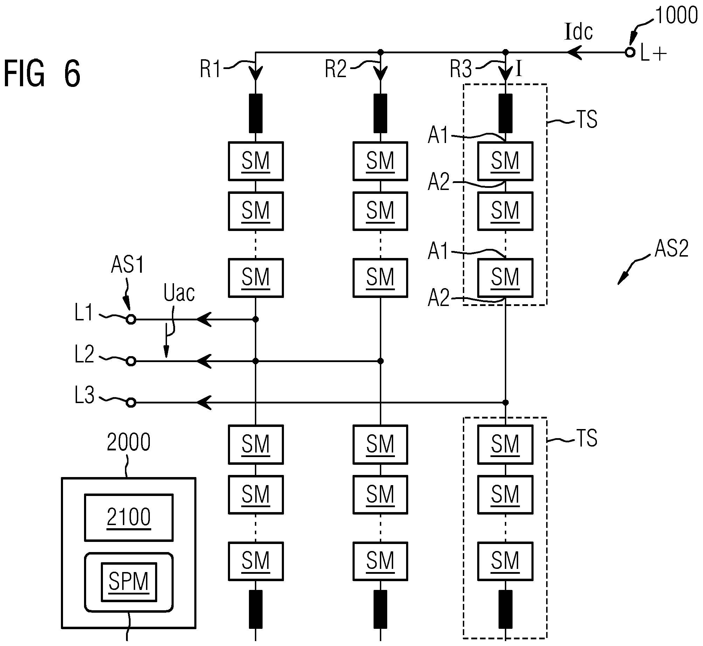

Die Figur 6 zeigt ein Ausführungsbeispiel für eine elektrische Anordnung in Form eines Umrichters 1000, beispielsweise wie gezeigt eines Multilevelumrichters, der mit Kurzschlussschalteinrichtungen 10, wie sie oben erläutert worden sind, ausgestattet ist. Der Umrichter 1000 weist auf seiner ersten Anschlussseite AS1 drei Wechselspannungsanschlüsse L1, L2 und L3 auf, an denen jeweils ein Wechselstrom in den Umrichter 1000 eingespeist oder aus diesem entnommen werden kann. Auf einer zweiten Anschlussseite AS2 befinden sich zwei Gleichspannungsanschlüsse, an denen ein Gleichstrom Idc in den Umrichter 1000 eingespeist oder aus diesem entnommen werden kann; diese sind in der Figur 6 mit dem Bezugszeichen L+ und L- gekennzeichnet.

Die Gleichspannung zwischen den Gleichspannungsanschlüssen L+ und L- trägt das Bezugszeichen Udc. Die jeweils zwischen den Wechselspannungsanschlüssen L1, L2 und L3 anliegende Wechselspannung trägt das Bezugszeichen Uac.

Der Umrichter 1000 weist drei Reihenschaltungen R1, R2 und R3 auf, deren äußere Anschlüsse die Gleichspannungsanschlüsse L+ und L- des Umrichters 1000 bilden. Die Reihenschaltungen R1, R2 und R3 umfassen jeweils zwei in Reihe geschaltete Modulreihenschaltungen TS.

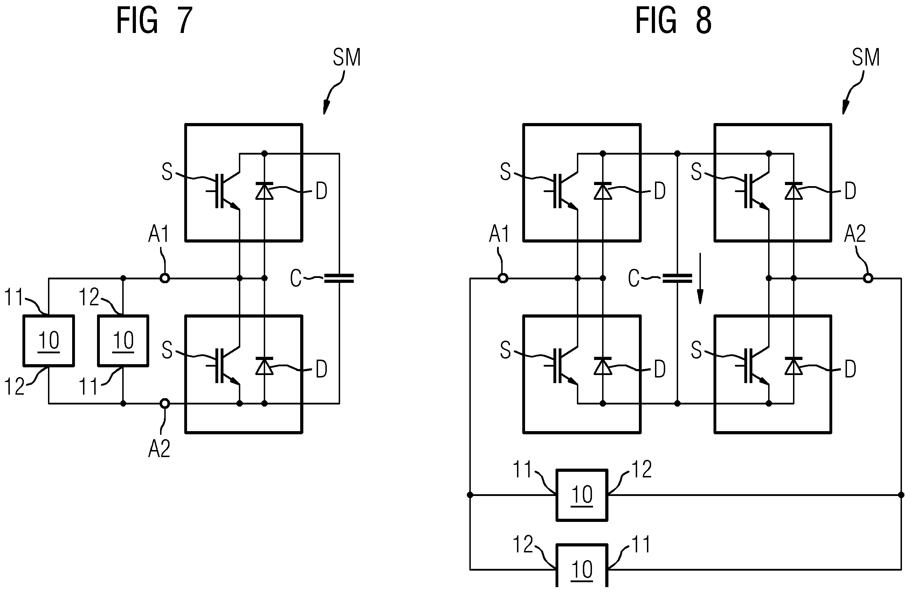

Jede der Modulreihenschaltungen TS weist jeweils mindestens zwei in Reihe geschaltete Teilmodule SM auf, die jeweils mindestens zwei Schaltelemente und einen Kondensator umfassen. Ausführungsbeispiele für geeignete Teilmodule SM werden nachfolgend beispielhaft im Zusammenhang mit den Figuren 7 und 8 erläutert.

Der Umrichter 1000 weist eine Steuereinrichtung 2000 auf, die zur Ansteuerung der Teilmodule SM und damit zur Ansteuerung der Modulreihenschaltungen TS geeignet ist. Die Steuereinrichtung 2000 weist zu diesem Zweck eine Recheneinrichtung 2100 sowie einen Speicher 2200 auf. In dem Speicher 2200 ist ein Steuerprogrammmodul SPM gespeichert, das die Arbeitsweise der Recheneinrichtung 2100 bestimmt.

Die Figur 7 zeigt ein Ausführungsbeispiel für ein Teilmodul SM, das zwei Schaltelemente S in Form von Transistoren, denen jeweils eine Diode D parallel (bzw. antiparallel) geschaltet ist, sowie als Energiespeicher einen Kondensator C umfasst. Die genannten Komponenten bilden eine Halbbrückenschaltung, die durch Ansteuern der Schaltelemente S - seitens der Steuereinrichtung 2000 gemäß Figur 6 - einen lediglich bzw. ausschließlich unipolaren Betrieb des Kondensators C ermöglicht.

Die Transistoren und die jeweils parallel geschalteten Dioden D können vorgefertigte Bauteile sein, wie in den Figuren zeichnerisch durch Kästen angedeutet ist; die Transistoren und die jeweils parallel geschalteten Dioden D können beispielsweise IGBT-Bauelemente sein.

Zu den zwei Anschlüsse A1 und A2 sind zwei Kurzschlussschalteinrichtungen 10 parallel geschaltet, und zwar mit unterschiedlicher Polarität; so zeigt die Figur 7, dass die Anschlüsse A1 und A2 jeweils mit der Anode 11 der einen Kurzschlussschalteinrichtung und der Kathode 12 der anderen Kurzschlussschalteinrichtung 10 verbunden sind. Die Kurzschlussschalteinrichtungen 10 sind vorzugsweise solche, wie sie oben im Zusammenhang mit den Figuren 1 bis 5 beschrieben worden sind. Durch den antiparallelen Anschluss der zwei Kurzschlussschalteinrichtungen 10 wird ein bidirektionaler Kurzschluss ermöglicht, weil zumindest eine der zwei Kurzschlussschalteinrichtungen 10 nach einer pyrotechnischen Zündung aufgrund des in Flussrichtung gepolten ersten pn-Übergangs 221 leitfähig ist.

Die Figur 8 zeigt ein Ausführungsbeispiel für ein Teilmodul SM, das vier Schaltelemente S in Form von Transistoren, denen jeweils eine Diode parallel geschaltet ist, sowie als Energiespeicher einen Kondensator C umfasst. Die genannten Komponenten bilden eine Vollbrückenschaltung, die durch Ansteuern der Schaltelemente S - seitens der Steuereinrichtung 2000 gemäß Figur 6 - einen bipolaren Betrieb des Kondensators C ermöglicht. Parallel zu den zwei Anschlüssen A1 und A2 sind wieder (antiparallel zueinander) zwei Kurzschlussschalteinrichtungen 10 geschaltet, vorzugsweise solche, wie sie oben im Zusammenhang mit den Figuren 1 bis 5 beschrieben worden sind.

## Patentansprüche

1. Kurzschlussschalteinrichtung (10), insbesondere Bypass-schalter,
wobei
- die Kurzschlussschalteinrichtung (10) ein Halbleiterelement (20) mit zumindest einem pn-Übergang (223) und mindestens eine pyrotechnische Zündeinrichtung (30) umfasst,
- wobei das Halbleiterelement (20) vor dem Zünden der pyrotechnischen Zündeinrichtung (30) aufgrund der Mitwirkung des pn-Übergangs (223) einen Sperrzustand aufweist oder zumindest aufweisen kann und
- wobei das Halbleiterelement (20) nach dem Zünden der pyrotechnischen Zündeinrichtung (30) von dem von der Zündeinrichtung (30) nach einer Explosion freigesetzten Explosionsgas (G) zumindest partiell, und zwar zumindest bezüglich des zumindest einen pn-Übergangs (223), zerstört und stromflussrichtungsunabhängig leitfähig gemacht wird.

2. Kurzschlussschalteinrichtung (10) nach Anspruch 1,
wobei
- die Kurzschlussschalteinrichtung (10) eine Anode (11) und eine Kathode (12) umfasst,
- wobei das Halbleiterelement (20) ein erstes und ein zweites n-dotiertes Halbleitergebiet (211, 212) aufweist, von denen das zweite mit der Kathode (12) verbunden ist oder diese selbst bildet,
- wobei das Halbleiterelement (20) ein erstes und ein zweites p-dotiertes Halbleitergebiet (201, 202) aufweist, von denen das erste mit der Anode (11) verbunden ist oder diese selbst bildet,
- wobei das erste und das zweite n-dotierte Halbleitergebiet (211, 212) und das erste und das zweite p-dotierte Halbleitergebiet (201, 202) zwischen der Anode (11) und der Kathode (12) zumindest drei elektrisch in Reihe liegende pn-Übergänge (221, 222, 223) bilden, nämlich einen ersten pn-Übergang (221) zwischen dem ersten p-dotierten Halbleitergebiet (201) und dem ersten n-dotierten Halbleitergebiet (211), einen zweiten pn-Übergang (222) zwischen dem ersten n-dotierten Halbleitergebiet (211) und dem zweiten p-dotierten Halbleitergebiet (202) und einen dritten pn-Übergang (223) zwischen dem zweiten p-dotierten Halbleitergebiet (202) und dem zweiten n-dotierten Halbleitergebiet (212), und
- wobei die pyrotechnische Zündeinrichtung (30) derart angeordnet ist, dass sie mit dem von ihr nach einer Explosion freigesetzten Explosionsgas (G) zumindest den dritten pn-Übergang (223) zerstört und dadurch stromflussrichtungsunabhängig leitfähig macht.

3. Kurzschlussschalteinrichtung (10) nach Anspruch 2,
wobei die pyrotechnische Zündeinrichtung (30) derart angeordnet ist, dass sie mit dem von ihr nach einer Explosion freigesetzten Explosionsgas (G) zumindest den zweiten und dritten pn-Übergang (222, 223) zerstört und stromflussrichtungsunabhängig leitfähig macht.

4. Kurzschlussschalteinrichtung (10) nach einem der voranstehenden Ansprüche,
wobei das Halbleiterelement (20) eine Halbleiterscheibe mit einer ersten und einer der ersten Scheibenseite (21) gegenüberliegenden zweiten Scheibenseite (22) ist.

5. Kurzschlussschalteinrichtung (10) nach Anspruch 4,
wobei
- die pyrotechnische Zündeinrichtung (30) eine Sprengladung (31) und einen Gasleitkanal (32) aufweist, der parallel zur Ebene der Halbleiterscheibe angeordnet ist und das von der Sprengladung (31) erzeugte Explosionsgas (G) parallel in Richtung Scheibenmitte leitet,
- wobei das nach einer Explosion freigesetzte Explosionsgas (G) den zumindest einen pn-Übergang (223), insbesondere den dritten pn-Übergang (223), im Bereich der Scheibenmitte zerstört und stromflussrichtungsunabhängig leitfähig macht.

6. Kurzschlussschalteinrichtung (10) nach einem der voranstehenden Ansprüche,
wobei das nach einer Explosion freigesetzte Explosionsgas (G) auch den zweiten pn-Übergang (222) im Bereich der Scheibenmitte zerstört und stromflussrichtungsunabhängig leitfähig macht.

7. Kurzschlussschalteinrichtung (10) nach einem der voranstehenden Ansprüche,
wobei das Halbleiterelement (20) eine Halbleiterscheibe ist,
- auf deren erster Scheibenseite (21) das erste p-dotierte Halbleitergebiet (201) und die Anode (11) und
- auf deren anderer zweiter Scheibenseite (22) das zweite n-dotierte Halbleitergebiet (212) und die Kathode (12) angeordnet sind.

8. Kurzschlussschalteinrichtung (10) nach einem der voranstehenden Ansprüche, wobei
- die Kurzschlussschalteinrichtung (10) eine Elektrode (40) umfasst, die auf einer der Scheibenseiten (22) aufliegt und die Anode (11) oder die Kathode (12) elektrisch kontaktiert, und
- der Gasleitkanal (32) der pyrotechnischen Zündeinrichtung (30) durch einen kanalförmigen Hohlraum (41) innerhalb der Elektrode (40), insbesondere durch ein innerhalb des kanalförmigen Hohlraums (41) angeordnetes Röhrchen, gebildet wird.

9. Kurzschlussschalteinrichtung (10) nach einem der voranstehenden Ansprüche,
wobei die pyrotechnische Zündeinrichtung (30) das nach einer Explosion freigesetzte Explosionsgas (G) auf eine auf dem Halbleiterelement (20) aufgebrachte Metallisierung oder zumindest auch auf die Metallisierung richtet.

10. Kurzschlussschalteinrichtung (10) nach einem der voranstehenden Ansprüche,
wobei das erste und zweite n-dotierte Halbleitergebiet (211, 212) und das erste und zweite p-dotierte Halbleitergebiet (201, 202) einen Thyristor bilden, bei dem das zweite p-dotierte Halbleitergebiet (202) einen Gatebereich des Thyristors bildet.

11. Kurzschlussschalteinrichtung (10) nach einem der voranstehenden Ansprüche,
wobei sich das zweite p-dotierte Halbleitergebiet (202) in Richtung einer der zwei Scheibenseiten (22) erstreckt und von einer auf dieser Scheibenseite (22) aufgebrachten Gateelektrode (13) kontaktiert wird.

12. Kurzschlussschalteinrichtung (10) nach einem der voranstehenden Ansprüche,
wobei die pyrotechnische Zündeinrichtung (30) das nach einer Explosion freigesetzte Explosionsgas (G) auf eine den Gatebereich kontaktierende Gateelektrode (13) oder zumindest auch auf die Gateelektrode (13) richtet.

13. Anordnung, insbesondere in Form eines Umrichters (1000), eines Multilevelumrichters, einer Spannungsstabilisierungseinrichtung, eines Blindleistungsstellers und/oder einer Blindleistungskompensationsanlage, mit zumindest einer Modulreihenschaltung (TS) mit mindestens zwei elektrisch in Reihe geschalteten Teilmodulen (SM) und einer Steuereinrichtung (2000) zum Ansteuern der Teilmodule (SM),
wobei die Anordnung zumindest eine Kurzschlussschalteinrichtung (10) nach einem der voranstehenden Ansprüche aufweist.

14. Anordnung nach Anspruch 13,
wobei die zumindest eine Kurzschlussschalteinrichtung (10) Bestandteil eines der Teilmodule (SM) ist und parallel zu den äußeren Anschlüssen (A1, A2) des Teilmoduls (SM) geschaltet ist und diese kurzschließen kann.

15. Verfahren zum Betreiben einer Kurzschlussschalteinrichtung (10), insbesondere eines Bypassschalters,
wobei
- die Kurzschlussschalteinrichtung (10) ein Halbleiterelement (20) mit zumindest einem pn-Übergang (223) und mindestens eine pyrotechnische Zündeinrichtung (30) umfasst,
- wobei das Halbleiterelement (20) vor dem Zünden der pyrotechnischen Zündeinrichtung (30) unter der Mitwirkung des pn-Übergangs in einen Sperrzustand geschaltet wird und
- wobei das Halbleiterelement (20) durch Zünden der pyrotechnischen Zündeinrichtung (30) mit dem von der Zündeinrichtung (30) nach einer Explosion freigesetzten Explosionsgas (G) zumindest partiell, und zwar zumindest bezüglich des zumindest einen pn-Übergangs, zerstört und stromflussrichtungsunabhängig leitfähig gemacht wird.

## Claims

1. Short-circuit switching device (10), in particular bypass switch,
wherein
- the short-circuit switching device (10) comprises a semiconductor element (20) with at least one p-n junction (223) and at least one pyrotechnic ignition device (30),
- wherein the semiconductor element (20) is or at least can be in a blocking state prior to the ignition of the pyrotechnic ignition device (30) on the basis of the involvement of the p-n junction (223), and
- wherein, after the ignition of the pyrotechnic ignition device (30), the semiconductor element (20) is at least partially destroyed, namely at least with respect to the at least one p-n junction (223), and is made at least partially conductive regardless of the current flow direction by the explosion gas (G) released by the ignition device (30) after an explosion.

2. Short-circuit switching device (10) according to Claim 1,
wherein
- the short-circuit switching device (10) comprises an anode (11) and a cathode (12),
- wherein the semiconductor element (20) has a first and a second n-doped semiconductor region (211, 212), of which the second is connected to the cathode (12) or forms same itself,
- wherein the semiconductor element (20) has a first and a second p-doped semiconductor region (21, 202), of which the first is connected to the anode (11) or forms same itself,
- wherein the first and the second n-doped semiconductor region (211, 212) and the first and the second p-doped semiconductor region (201, 202) form at least three p-n junctions (221, 222, 223) electrically in series between the anode (11) and the cathode (12), namely a first p-n junction (221) between the first p-doped semiconductor region (201) and the first n-doped semiconductor region (211), a second p-n junction (222) between the first n-doped semiconductor region (211) and the second p-doped semiconductor region (202), and a third p-n junction (223) between the second p-doped semiconductor region (202) and the second n-doped semiconductor region (212), and
- wherein the pyrotechnic ignition device (30) is arranged in such a way that it destroys at least the third p-n junction (223) and as a result makes it conductive regardless of the current flow direction by way of the explosion gas (G) released by it after an explosion.

3. Short-circuit switching device (10) according to Claim 2,
wherein
the pyrotechnic ignition device (30) is arranged in such a way that it destroys at least the second and third p-n junction (222, 223) and as a result makes them conductive regardless of the current flow direction by way of the explosion gas (G) released by it after an explosion.

4. Short-circuit switching device (10) according to any one of the preceding claims,
wherein
the semiconductor element (20) is a semiconductor wafer with a first wafer side and a second wafer side (22) opposite the first wafer side (21).

5. Short-circuit switching device (10) according to Claim 4,
wherein
- the pyrotechnic ignition device (30) has an explosive charge (31) and a gas conduction duct (32) which is arranged in parallel with the plane of the semiconductor wafer and conducts the explosion gas (G) produced by the explosive charge (31) in parallel in the direction of the centre of the wafer,
- wherein the explosion gas (G) released after an explosion destroys the at least one p-n junction (223), in particular the third p-n junction (223), in the region of the centre of the wafer and makes it conductive regardless of the current flow direction.

6. Short-circuit switching device (10) according to any one of the preceding claims,
wherein
the explosion gas (G) released after an explosion also destroys the second p-n junction (222) in the region of the centre of the wafer and makes it conductive regardless of the current flow direction.

7. Short-circuit switching device (10) according to any one of the preceding claims,
wherein
the semiconductor element (20) is a semiconductor wafer,
- on the first wafer side (21) of which the first p-doped semiconductor region (201) and the anode (11) are arranged and
- on the other second wafer side (22) of which the second n-doped semiconductor region (212) and the cathode (12) are arranged.

8. Short-circuit switching device (10) according to any one of the preceding claims,
wherein
- the short-circuit switching device (10) comprises an electrode (40) which is supported on one of the wafer sides (22) and makes electrical contact with the anode (11) or the cathode (12), and
- the gas conduction duct (32) of the pyrotechnic ignition device (30) is formed by a duct-shaped cavity (41) within the electrode (40), in particular by a small tube arranged within the duct-shaped cavity (41).

9. Short-circuit switching device (10) according to any one of the preceding claims,
wherein
the pyrotechnic ignition device (30) directs the explosion gas (G) released after an explosion toward a metallization applied to the semiconductor element (20) or at least also toward the metallization.

10. Short-circuit switching device (10) according to any one of the preceding claims,
wherein
the first and second n-doped semiconductor region (211, 212) and the first and second p-doped semiconductor region (201, 202) form a thyristor in which the second p-doped semiconductor region (202) forms a gate region of the thyristor.

11. Short-circuit switching device (10) according to any one of the preceding claims,
wherein
the second p-doped semiconductor region (202) extends in the direction of one of the two wafer sides (22) and is contacted by a gate electrode (13) applied to said wafer side (22).

12. Short-circuit switching device (10) according to any one of the preceding claims,
wherein
the pyrotechnic ignition device (30) directs the explosion gas (G) released after an explosion toward a gate electrode (13) that makes contact with the gate region or at least also toward the gate electrode (13).

13. Arrangement, in particular in the form of a converter (1000), a multilevel converter, a voltage stabilization device, a reactive power controller and/or a reactive power compensation system, having at least one module series circuit (TS) having at least two submodules (SM) connected electrically in series and a control device (2000) for actuating the submodules (SM), wherein
the arrangement has at least one short-circuit switching device (10) according to any one of the preceding claims.

14. Arrangement according to Claim 13,
wherein
the at least one short-circuit switching device (10) is a component part of one of the submodules (SM) and is connected in parallel with the outer connections (A1, A2) of the submodule (SM) and can short-circuit same.

15. Method for operating a short-circuit switching device (10), in particular a bypass switch,
wherein
- the short-circuit switching device (10) comprises a semiconductor element (20) with at least one p-n junction (223) and at least one pyrotechnic ignition device (30),
- wherein the semiconductor element (20) is switched to a blocking state prior to the ignition of the pyrotechnic ignition device (30) on the basis of the involvement of the p-n junction, and
- wherein, through ignition of the pyrotechnic ignition device (30), the semiconductor element (20) is at least partially destroyed, namely at least with respect to the at least one p-n junction, and is made at least partially conductive regardless of the current flow direction by the explosion gas (G) released by the ignition device (30) after an explosion.

## Revendications

1. Dispositif (10) de commutation à court-circuit, en particulier interrupteur à court-circuit,
dans lequel
- le dispositif (10) de commutation à court-circuit comprend un élément (20) à semiconducteur ayant au moins une jonction pn (223) et au moins un dispositif (30) pyrotechnique d'amorçage,
- dans lequel l'élément (20) à semiconducteur a, avant l'amorçage du dispositif (30) pyrotechnique d'amorçage sur la base du concours de la jonction pn (223), un état bloqué ou du moins peut l'avoir, et
- dans lequel l'élément (20) à semiconducteur est, après l'amorçage du dispositif (30) pyrotechnique d'amorçage, détruit au moins partiellement, et de fait au moins en ce qui concerne la au moins une jonction pn (223), par le gaz (G) d'explosion dégagé par le dispositif (30) amorçage après une explosion et est rendu conducteur indépendamment du sens de flux du courant.

2. Dispositif (10) de commutation à court-circuit suivant la revendication 1,
dans lequel
- le dispositif (10) de commutation à court-circuit comprend une anode (11) et une cathode (12),
- dans lequel l'élément (20) à semiconducteur a un premier et un deuxième domaines (211, 212) semiconducteurs à dopage n, dont le deuxième est relié à la cathode (12) ou forme soi même celle-ci,
- dans lequel l'élément (20) à semiconducteur a un premier et un deuxième domaines (201, 202) semiconducteurs à dopage p, dont le premier est relié à l'anode (11) ou forme soi même celle-ci,
- dans lequel le premier et le deuxième domaines (211, 212) semiconducteurs à dopage n et le premier et le deuxième domaines (201, 202) semiconducteurs à dopage p forment, entre l'anode (11) et la cathode (12), au moins trois jonctions pn (221, 222, 223) électriquement en série, à savoir une première jonction (221) pn entre le premier domaine (201) semiconducteur à dopage p et le premier domaine (211) semiconducteur à dopage n, une deuxième jonction (222) pn entre le premier domaine (211) semiconducteur à dopage n et le deuxième domaine (202) semiconducteur à dopage p et une troisième jonction (223) entre le deuxième domaine (202) semiconducteur à dopage p et le deuxième domaine (212) semiconducteur à dopage n, et
- dans lequel le dispositif (30) pyrotechnique d'amorçage est disposé de manière à ce qu'il détruise, par le gaz (G) d'explosion dégagé par lui après une explosion, au moins la troisième jonction pn (223) et la rende ainsi conductrice indépendamment du sens de flux du courant.

3. Dispositif (10) de commutation à court-circuit suivant la revendication 2,
dans lequel
le dispositif (30) pyrotechnique d'amorçage est disposé de manière à ce qu'il détruise, par le gaz (G) d'explosion dégagé par lui après une explosion, au moins la deuxième et la troisième jonctions pn (222, 223) et les rende conductrices indépendamment du sens de flux du courant.

4. Dispositif (10) de commutation à court-circuit suivant l'une des revendications précédentes,
dans lequel
l'élément (20) à semiconducteur est une plaquette à semiconducteur ayant une première face et une deuxième face (22) opposée à la première face (21).

5. Dispositif (10) de commutation à court-circuit suivant la revendication 4,
dans lequel
- le dispositif (30) pyrotechnique d'amorçage a une charge (31) explosive et un conduit (32) pour du gaz, qui est disposé parallèlement au plan de la plaquette à semiconducteur et qui conduit le gaz (G) d'explosion produit par la charge (31) explosive parallèlement dans la direction du milieu de la plaquette,
- dans lequel le gaz (G) d'explosion dégagé après une explosion détruit la au moins une jonction pn (223), en particulier la troisième jonction pn (223) , dans la partie du milieu de la plaquette et la rend conductrice indépendamment du sens de flux du courant.

6. Dispositif (10) de commutation à court-circuit suivant l'une des revendications précédentes,
dans lequel
le gaz (G) d'explosion dégagé après une explosion détruit également la deuxième jonction pn (222) dans la partie du milieu de la plaquette et la rend conductrice indépendamment du sens de flux du courant.

7. Dispositif (10) de commutation à court-circuit suivant l'une des revendications précédentes,
dans lequel
l'élément (20) à semiconducteur est une plaquette à semiconducteur
- sur la première face (21) de laquelle sont disposés le premier domaine (201) semiconducteur à dopage p et l'anode (11), et
- sur l'autre deuxième face (22) de laquelle sont disposés le deuxième domaine (212) semiconducteur à dopage n et la cathode (12) .

8. Dispositif (10) de commutation à court-circuit suivant l'une des revendications précédentes,
dans lequel
- le dispositif (10) de commutation à court-circuit comprend une électrode (40), qui s'applique à l'une des faces (22) de la plaquette et qui contacte électriquement l'anode (11) ou la cathode (12), et
- le conduit (32) pour du gaz du dispositif (30) pyrotechnique d'amorçage est formé par une cavité (41) en forme de conduit à l'intérieur de l'électrode (40), en particulier par un petit tube disposé à l'intérieur de la cavité (41) en forme de conduit.

9. Dispositif (10) de commutation à court-circuit suivant l'une des revendications précédentes,
dans lequel
le dispositif (30) pyrotechnique d'amorçage dirige le gaz (G) d'explosion dégagé après une explosion sur une métallisation déposée sur l'élément (20) à semiconducteur ou du moins également sur la métallisation.

10. Dispositif (10) de commutation à court-circuit suivant l'une des revendications précédentes,
dans lequel
le premier et le deuxième domaines (211, 212) semiconducteurs à dopage n et le premier et le deuxième domaines (201, 202) semiconducteurs à dopage p forment un thyristor, dans lequel le deuxième domaine (202) semiconducteur à dopage p forme une partie de grille du thyristor.

11. Dispositif (10) de commutation à court-circuit suivant l'une des revendications précédentes,
dans lequel
le deuxième domaine (202) semiconducteur à dopage p s'étend dans la direction de l'une des deux faces (22) de la plaquette et est contacté par une électrode (13) de grille déposée sur cette face (22) de la plaquette.

12. Dispositif (10) de commutation à court-circuit suivant l'une des revendications précédentes,
dans lequel
le dispositif (30) pyrotechnique d'amorçage dirige le gaz (G) d'explosion dégagé après une explosion sur l'électrode (13) de grille contactant la partie de grille ou du moins également sur l'électrode (13) de grille.

13. Agencement, en particulier sous la forme d'un convertisseur (1000), d'un convertisseur à plusieurs niveaux, d'un dispositif de stabilisation de la tension, d'un régleur de la puissance réactive et/ou d'une installation de compensation de la puissance réactive, comprenant au moins un circuit (TS) série modulaire ayant au moins deux modules (SM) partiels montés électriquement en série et un dispositif (2000) de commande des modules (SM) partiels,
dans lequel
l'agencement a au moins un dispositif (10) de commutation à court-circuit suivant l'une des revendications précédentes.

14. Agencement suivant la revendication 13,
dans lequel
le au moins un dispositif (10) de commutation à court-circuit est une partie constitutive de l'un des modules (SM) partiels et est monté en parallèle avec les bornes (A1, A2) extérieures du module (SM) partiel et peut court-circuiter celui-ci.

15. Procédé pour faire fonctionner un dispositif (10) de commutation à court-circuit, en particulier un interrupteur à dérivation,
dans lequel
- le dispositif (10) de commutation à court-circuit comprend un élément (20) à semiconducteur ayant au moins une jonction pn (223) et au moins un dispositif (30) pyrotechnique d'amorçage,
- dans lequel on met l'élément (20) à semiconducteur, avant l'amorçage du dispositif (30) pyrotechnique d'amorçage avec le concours de la jonction pn, dans un état bloqué, et
- dans lequel l'élément (20) à semiconducteur est, par l'amorçage du dispositif (30) pyrotechnique d'amorçage, mis par le gaz (G) d'explosion dégagé par le dispositif (30) pyrotechnique d'amorçage après une explosion, détruit au moins en partie et de fait, au moins en ce qui concerne la au moins une jonction pn, est rendu conducteur indépendamment du sens de flux du courant.
